# EUROPEAN PATENT SPECIFICATION

(11) **EP 4 063 956 B1**
(45) Date of publication and mention of the grant of the patent: **10.12.2025**
(21) Application number: 21218103.6
(22) Date of filing: 29.12.2021
(51) Int. Cl.: G03F 7/20

(54) **UV EXPOSURE APPARATUS FOR FLEXOGRAPHIC PRINTING PLATES COMPRISING MULTIPLE UV LIGHT SOURCES**
VORRICHTUNG ZUR UV-EXPOSITION FÜR FLEXODRUCKPLATTEN MIT MEHREREN UV-LICHTQUELLEN
APPAREIL D'EXPOSITION AUX UV POUR PLAQUES D'IMPRESSION FLEXOGRAPHIQUES COMPRENANT DE MULTIPLES SOURCES DE LUMIÈRE UV

(30) Priority: 24.03.2021 US 202163165290 P
(43) Date of publication of application: 28.09.2022
(73) Proprietor: Esko-Graphics Imaging GmbH, 25524 Itzehoe (DE)
(72) Inventor: Sievers, Wolfgang, 25569 Kremperheide (DE)
(74) Representative: Müller-Boré & Partner Patentanwälte PartG mbB

(56) References cited:
- WO-A1-2020/148076
- WO-A1-2020/216948
- US-A1- 2003 081 106

## Description

### BACKGROUND OF THE INVENTION

In flexographic printing, exposure of digital photopolymer printing plates with UV LEDs has become state-of-the-art. The image is transferred to the plate by means of a mask on top of the polymer sheet. The mask blocks UV light or admits UV light to enter and cure the polymer plate beneath during an exposure step. An exemplary category of masks are referred to as Laser Ablate-able Mask (LAMs), and the layer of material that is ablated is often referred to as a LAMs layer. Exposure through the LAMs layer mask is called front exposure. In common flatbed embodiments, such as the Esko^{®} XPS^{™} exposure unit, the UV light source comprises a "linear source" that extends along one full lateral dimension of the polymer printing plate and moves in one or more passes along the other lateral dimension of the plate while exposing the polymer through the mask opening in the LAMs layer.

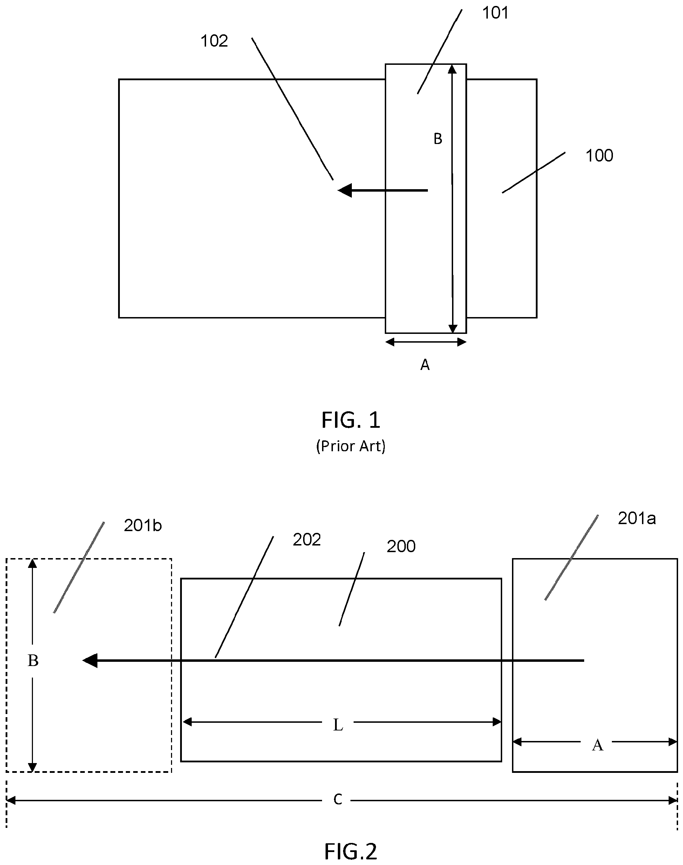

FIG. 1 shows such common linear source embodiment. The UV source 101, having the dimensions A and B, is located above a photopolymer printing plate 100. In the transverse dimension B, the source is preferably a little wider than the printing plate to ensure the plate is completely illuminated with UV light, while still allowing some tolerance for positioning of the plate relative to the UV source. Such a source may be referred to herein as being "coextensive" with a lateral dimension of the plate, meaning that it extends at least across the subject lateral dimension (but may extend further than that dimension, as is typical). The source moves along the polymer plate in the movement direction of arrow 102 perpendicular to dimension B.

In the depicted flatbed arrangement, the polymer printing plate typically rests on a transparent (e.g. glass) support surface. A second UV source is located underneath the support surface to provide back exposure. Back exposure is instrumental in providing support to the printing structures cured by the front side exposure.

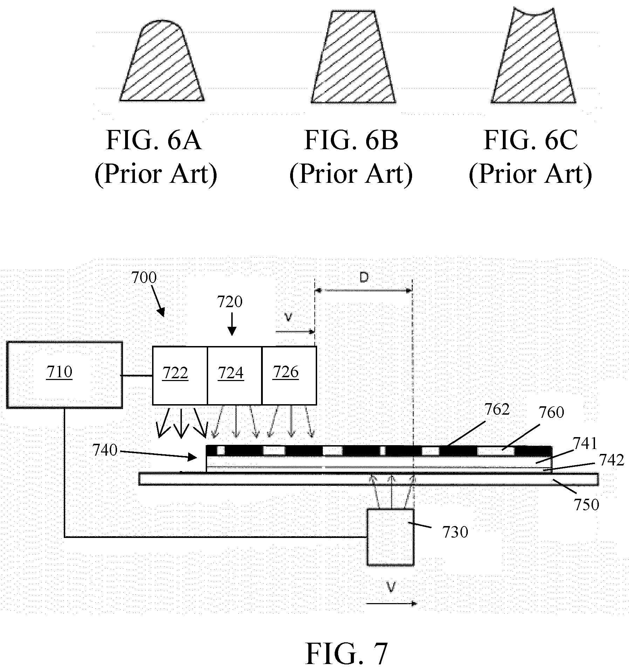

The UV exposure may be executed in multiple exposure steps or cycles during which the back and front exposure sources travel in multiple passes along the plate. Multiple passes are often desirable to apply the complete UV energy required for complete curing of the plate. If all of the energy were to be applied in only a single exposure step, the UV source would need to produce a higher UV power, which is more expensive than sources limited to producing at a relatively lower UV power. Another problem with applying all energy in a single exposure step is that the dots tend to exhibit so-called "cupping." Cupping forms the dot tips in a concave "cup" shape, such as is depicted in FIG. 6C, which may cause so-called "dot bridging" during printing.

With multiple passes, the number of passes can be used to influence the properties of the dot tips and the printing surface structures. A typical exposure cycle includes an illumination pass in one direction with the source emitting the curative radiation, and a return pass in the opposite direction with the source not emitting radiation.

In the flexographic industry, it is understood that the geometry of the "dots" on the printing plate that hold ink may vary from a relatively flat shape to a relatively rounder shape. One way of characterizing a flat top dot is that the structure of the flat-top dot has a single defined point where the shoulder of the dot meets the printable face of the dot, whereas a round top dot has a radius from the shoulder to face. Another way of characterizing a flat top dot is that a flat top dot has (or approaches) a 1:1 imaging to plate ratio. Exemplary round top dots are depicted in FIG. 6A and exemplary flat top dots are depicted in FIG 6B. The difference in geometry is understood by those of skill in the art as arising from a difference in the dot formation conditions with respect to oxygen inhibition. The absence or presence of oxygen during the main exposure process impacts sharpening or rounding of the dot formed in the photopolymer during the exposure step. Oxygen (from the environment and in the plate) inhibits the polymerization reaction, making polymer chains shorter, which leads to more washout of polymer during plate processing. Accordingly, systems with the least oxygen inhibition (e.g. the least oxygen present) tend to have flatter dotes. Platemaking systems in which the image-carrying-mask is embodied in a film, which was the earliest used technology in photopolymer flexography, typically have minimal to no oxygen present that can reach the photopolymer from the environment during the exposure step, and thus have the least oxygen inhibition of the curing. Thus, chronologically, the first type of dots formed on plates used for polymer flexography were what are now referred to as "flat top dots." Later, with invention of LAMs technology, round dots were obtained when a bank exposure device was used for curing, because of the oxygen inhibition that took place at the low irradiance of bank exposure. Round top dots enable the printing of smaller highlight dots, but typically require more effort to adjust the press settings, making print results somewhat dependent on the printer's skills. U.S. Patent No. 8,227,769B2, titled "CURING OF PHOTO-CURABLE PRINTING PLATES WITH FLAT TOPS OR ROUND TOPS, describes a practicable way for converting round top dots in a LAMs-based system towards the flat top dots historically known in film-based systems, while still selectively enabling formation of round top dots, in order to enjoy the advantages of both from a single exposure system.

Plate vendors developed have also developed highly sensitive polymer printing plates that produce flat top dots using the low UV intensity of a bank light exposure system equipped with low intensity fluorescent tubes. Some examples of such plates include, e.g., Nyloflex^{®} FTH^{™} by Flint or the Cyrel^{®} EASY EPC^{™} by DuPont. Sometimes these plates are referred to as Flat Top In-the-Plate (ITP) plates. As prices for UV LEDs have declined, and because of their stability and long life cycles, UV LEDs systems have became more common, and increasingly have been used for exposures of such highly sensitive ITP plates, which have become well established in the field of flexographic printing.

Typically, exposure of ITP plates using UV LED systems involves setting the UV output power of the LEDs well below their nominal designed power, to avoid the high irradiance levels typically emitted by UV LED systems. High irradiance levels may cause unwanted artefacts on the polymer plates, such as line broadening or surface cracks.

Therefore, the UV power is typically lowered to a level closer to the irradiance of bank exposure systems, which typically operate in the range of around 16-20 mW/cm². Experience has shown that a setting of 50 mW/cm² in a UV LED system is operable for most ITP plates without producing artefacts.

Lowering the power in a UV LED system introduces the challenge of finding the correct power adjustment for each set of independently controllable LEDs to balance the light source along the transverse dimension B. UV LEDs for UV exposure heads are typically supplied on reels carrying LEDs from different wafers. As not all LEDs have identical output power and electrical characteristics, the output power for a given current is slightly different from one LED to another. Even with binning, there are still differences among the LEDs on the same reel. The absolute difference in output power over the length of the UV source is preferably smaller than 5%, to avoid visible differences on the different areas of the polymer printing plate. Accordingly, the output power is typically adjusted within a predetermined tolerance for each individual LED, or at least for individually controllable groups of LEDs, arranged along the UV source in direction B. Due to the different electrical characteristics of the LEDs, every change in the normal output power of operation also slightly changes the balancing.

While it is relatively easy to adjust the LED balancing in a regime close to their nominal output power, it is more difficult to make this adjustment at, *e.g.,* 10% of total output power. To adjust at 10% of the nominal UV power, within an accuracy of less than 5% difference, requires an absolute accuracy of 0.5%.

This challenge is exacerbated by the fact that modern digital control circuits typically only permit the power to be measured and adjusted in digital increments, which further limits accuracy at low power settings. Furthermore, the wavelength emitted by the LEDs drifts with the LED chip temperature, which in turn is influenced by the average output power. Thus, changing the average UV power may additionally change the center wavelength of the UV emissions, and therefore change curing efficiency of the UV light.

For the forgoing reasons, it is more optimal to balance and operate a UV LED exposure source at a relatively higher power level and to operate UV light sources for polymer plate exposure at a generally fixed UV output power level.

Another problem with lowering UV power is that low UV power slows down the curing process, because it takes longer to apply the energy per unit surface area necessary for complete curing of the polymer plate. Therefore, a UV LED head operated at reduced UV power will need more time compared to a bank exposure system to expose an ITP plate. This limits the throughput of polymer plates produced using an UV LED exposure unit and puts UV LED systems at a disadvantage relative to bank exposure systems operating at higher UV power levels and thus capable of generating higher throughput.

Accordingly, there is a need in the art for systems and methods that eliminate, minimize, or mitigate the foregoing disadvantages of flatbed UV LED exposure systems using a moveable linear source.

Furthermore, WO 2020/148 076 A1 relates to processes for producing optical effect layers (OELs) comprising non-spherical magnetic or magnetizable particles and comprising a motif made of at least two areas made of a single applied and cured layer, said motif being obtained by using a selective curing performed by irradiation with an actinic radiation LED source comprising an array of individually addressable actinic radiation emitters.

US 2003/081106 A1 relates to a method for exposing a printing form, wherein the method includes providing a plurality of exposure channels disposed in a two-dimensional array, and inputting energy, by the exposure channels of a column of the array, for an image element on the printing form. WO 2020/216948 A1 relates to an apparatus and a method exposing a printing form, wherein an array of individually controllable LEDs is used.

### SUMMARY OF THE INVENTION

One aspect of the invention relates to a UV exposure apparatus as defined by the independent claim 1.

In some embodiments, the plurality of front UV LED radiation sources have a fixed intensity. The controller may be configured to control the total exposure energy applied to the plate by the linear front exposure head within a given exposure time by controlling a maximum total number of linear subgroups activated simultaneously. In embodiments, the controller is configured to distribute the total exposure energy applied to the plate by the linear front exposure head over a plurality of front exposure cycles.

The apparatus may further include a back UV exposure source configured to emit radiation toward a back surface of the plate disposed on the substrate. In such embodiments, the controller is configured to control the back UV exposure source to apply the back exposure sequentially before a first front exposure cycle, between a pair of sequential front exposure cycles, or a combination thereof. In some embodiments, the back exposure source may be configured to emit the radiation toward the back surface of the plate in a back irradiation field coextensive with the first lateral dimension of the plate and coextensive with the second lateral dimension of the plate. In other embodiments, the back exposure source is configured to emit the radiation toward the back surface of the plate in a back irradiation field coextensive with the first lateral dimension of the plate and non- coextensive with the second lateral dimension of the plate. The back exposure source may precede the front exposure source in the first movement direction, and a distance between a leading edge of the front exposure source and a leading edge of the back exposure source may be adjustable so that a constant time difference between beginning of back and beginning of front exposure is attainable for a range of movement speeds.

One or more of the linear subgroups positioned adjacent a leading edge of the linear front exposure head may comprise UV LED point sources with a higher intensity than corresponding UV LED point sources in the remaining linear subgroups that have a lower intensity. One or more of the linear subgroups positioned adjacent a leading edge of the linear front exposure head may be controllable between at least the higher intensity and the lower intensity. In some embodiments, the controller may be configured to cause emission of the collective irradiation field in only the first movement direction.

One or more of the linear subgroups may positioned to illuminate a portion of the plate when in an activated state in the starting rest position or the ending rest position of the linear subsource. The controller is configured to selectively activate and deactivate the linear subgroups in a first sequence to mimic relative motion of the linear subgroups relative to the plate in a first part of at least one exposure cycle in which the linear front exposure head is in the starting rest position, cause actual relative motion in the first movement direction in a second part of the at least one exposure cycle, and selectively activate and deactivate the linear subgroups in a second sequence to mimic relative motion of the linear subgroups relative to the plate with the linear front exposure head in the ending rest position in a third part of the at least one exposure cycle. In some embodiments, the controller is configured to cause the linear front exposure head to return from the ending rest position to the starting rest position in a second movement direction opposite the first movement direction with none of the linear subgroups activated. In other embodiments, the controller is configured to cause a third sequence of selective activation and deactivation of the linear subgroups in a fourth part of the at least one exposure cycle with the linear front exposure head in the ending rest position, cause actual relative motion in a second movement direction opposite the first movement direction in a fifth part of the at least one exposure cycle, and cause a fourth sequence of selective activation and deactivation of the linear subgroups in a sixth part of the at least one exposure cycle with the linear front exposure head in the starting rest position. The controller may be configured to activate all of the linear subgroups during the second part of the at least one exposure cycle, or it may be configured to activate fewer than all of the linear subgroups during the second part of the at least one exposure cycle.

In some embodiments, the controller is configured to activate fewer than all of the linear subgroups during a relative motion portion of the at least one exposure cycle. In some embodiments, none of the linear subgroups is positioned to illuminate the plate when in an activated state in one or both of the starting rest position and the ending rest position. The controller may be configured to activate fewer than all of the linear subgroups during a relative motion portion of the at least one exposure cycle.

In embodiments, at least one adjacent pair of the one or more of the linear subsources are spaced apart from one another with a spacing that is adjustable. Multiple adjacent pairs of linear subsources may have an adjustable spacing between them, and may be connected to one another with a mechanism configured to adjust the spacing between multiple adjacent pairs using a single driver, or each linear subsource in the multiple adjacent pairs may be connected to an independently controllable positioner. The controller may be configured to regulate intensity of exposure by adjusting the spacing between two or more subsources. In some embodiments, the controller is configured to cause exposure of a portion of the plate in the first movement direction by causing a first activated linear subsource to move in the first movement direction relative to a second linear subsource, including in some embodiments, causing the first activated linear subsource to move relative to the second linear subsource at a time when the second linear subsource is not positioned over the plate.

Another aspect of the invention is a method for curing a flexographic photopolymer printing plate as defined by the independent claim 13.

Embodiments of the method may include controlling the total exposure energy applied to the plate by the linear front exposure head within a given exposure time by controlling a maximum total number of linear subgroups activated simultaneously during each at least one front exposure cycle. The total exposure energy may be applied to the plate by the linear front exposure head over a plurality of front exposures cycles. The method may further include emitting radiation toward a back surface of the plate sequentially before a first front exposure cycle, between a pair of sequential front exposure cycles, or a combination thereof. The radiation emitted toward the back surface of the plate may define a back irradiation field coextensive with the first lateral dimension of the plate and coextensive with the second lateral dimension of the plate.

A higher intensity of radiation may be provided adjacent a leading edge of the linear front exposure head than in a remaining portion of the linear front exposure head. One or more of the linear subgroups may be positioned to illuminate a portion of the plate when in an activated state in a starting or ending resting position of the linear subgroup. In such embodiments, the method may include selectively activating and deactivating the linear subgroups in a first sequence to mimic relative motion of the linear subgroups relative to the plate in a first part of at least one front exposure cycle when the linear front exposure head is in the starting rest position, actual relative motion between the plate and the UV head in the first movement direction in a second part of the at least one front exposure cycle, and selectively activating and deactivating the linear subgroups in a second sequence to mimic relative motion of the linear subgroups relative to the plate when the linear front exposure head is in the ending rest position in a third part of the at least one front exposure cycle.

In some embodiments, relative motion may return the linear front exposure head from the ending rest position to the starting rest position in a second movement direction opposite the first movement direction with none of the linear subgroups activated. Such embodiments may include performing a third sequence of selective activation and deactivation of the linear subgroups in a fourth part of the at least one front exposure cycle with the linear front exposure head in the ending rest position, actual relative motion between the UV head and the plate in a second movement direction opposite the first movement direction in a fifth part of the at least one front exposure cycle, and performing a fourth sequence of selective activation and deactivation of the linear subgroups in a sixth part of the at least one front exposure cycle with the linear front exposure head in the starting rest position. In embodiments, all of the linear subgroups may be activated during the second part of the at least one front exposure cycle, or fewer than all of the linear subgroups may be activated. In embodiment, fewer than all of the linear subgroups during the relative motion portion of the one or more front exposure cycles.

Printing dot top geometry may be controlled by controlling a maximum total number of linear subgroups activated simultaneously during the one or more front exposure cycles. The method may include adjusting a spacing between two or more of the linear subsources. Respective spacing between multiple adjacent pairs of linear subsources may be adjusted while maintaining spacing between a first adjacent pair equal to spacing between a second adjacent pair, or may comprise independently adjusting respective spacing between multiple adjacent pairs of linear subsources.

Intensity of exposure may be regulated by adjusting the spacing between two or more of the linear subsources. A portion of the plate in the movement direction may be exposed by causing a first activated linear subsource to move in the movement direction relative to a second linear subsource. In such embodiments, the second linear subsource may not be positioned over the plate during the movement of the first linear subsource.

### BRIEF DESCRIPTION OF THE DRAWINGS

FIG. 1 is a schematic plan view drawing of a prior art flatbed UV exposure system comprising a movable linear exposure head.
FIG. 2 is a schematic plan view drawing of an exemplary layout of a flatbed UV exposure system having a movable linear exposure head with a relatively wider aperture in the moving direction than the system in FIG. 1.
FIG. 3 is a schematic side view drawing of an exemplary linear UV exposure system having a movable linear exposure head with a plurality of independently controllable subset linear sources and having starting and ending rest positions in which some of the subset linear sources are aligned over a portion of the plate, showing in STEPS A-H, an exemplary sequence of illumination and movement of the exposure head.
FIG. 4 is a schematic side view drawing of an exemplary linear UV exposure system comprising a movable linear exposure head having a plurality of independently controllable subset linear sources, depicting an operating condition in which fewer than all of subset linear sources are illuminated during movement of the exposure head.
FIG. 5 is a schematic plan view drawing of an exemplary linear UV exposure system comprising a movable linear exposure head having a plurality of subset linear sources in which one or more subset linear sources on a leading edge of the exposure head has a higher intensity than the remaining subset linear sources.
FIG. 6A is a schematic cross-sectional drawing of an exemplary round top halftone dot.
FIG. 6B is a schematic cross-sectional drawing of an exemplary flat top halftone dot.
FIG. 6C is a schematic cross-sectional drawing of an exemplary concave "cupped" top halftone dot.
FIG. 7 is a schematic side view drawing of an embodiment of an exemplary exposure system having a moveable linear back exposure unit.
FIG. 8 is a schematic side view drawing of an embodiment of an exemplary exposure system having an area linear back exposure unit coextensive with both lateral dimensions of the plate.
FIG. 9A is a schematic side view drawing of an embodiment of an exemplary exposure system having adjustable spacing between adjacent subsources, comprising a scissor linkage mechanism with a linear actuator for adjusting spacing between multiple connected subsources, in an expanded configuration.
FIG. 9B is a schematic side view drawing of the exemplary exposure system embodiment of FIG. 9A in a compressed configuration.
FIG. 9C is a schematic side view drawing of another embodiment of an exemplary exposure system having adjustable spacing between adjacent subsources, comprising a rack and gear system with a single driver for adjusting spacing between multiple connected subsources.
FIG. 9D is a schematic side view drawing of an embodiment of an exemplary exposure system having adjustable spacing between adjacent subsources comprising independently controllable positioner systems for each subsource.

### DETAILED DESCRIPTION OF THE INVENTION

One aspect of the invention is to provide a UV LED exposure apparatus that distributes the emitted UV LED power across a relatively wider aperture (in the movement direction), as compared to prior art system apertures, without significantly increasing the total amount of UV power relative to prior art systems.

In Esko's prior art 5080 XPS flatbed UV system, the UV emitting aperture area has dimensions A x B of approximately 16 x 130 cm, and the intensity emitted from this aperture is 312 mW/cm². The total UV power emitted from such a system is thus 16 cm x 130 cm x 0.312 W/cm², which is equivalent to about 650 Watts of total UV power. In an exemplary system in accordance with one aspect of this invention, the 650 Watts may be distributed over a multitude of independently controllable linear UV subsources collectively having a total aperture area of, e.g., 96 x 130 cm. The resulting irradiance of such a configuration is also 52 mW/cm². Each linear UV LED subsource comprises a plurality of UV LED point sources arranged in a row or array to provide balanced light emission across one dimension of the plate. As used herein, the term "collective UV source" or "UV head" refers to the plurality of linear UV subsources, the term "linear UV subsource" refers to each set of UV point sources arranged in a line or a linear array comprising multiple commonly controlled lines, and the term "UV point source" refers to each light-emitting diode. Each LED may be individual controllable as a point source, or only in subsets of multiple point sources.

Applicant has found that most plates can be cured with flat tops using an exposure irradiance of 50 mW/cm². Thus, a preferred range of exposure irradiance is in the range of 50-100 mW/cm².

Fine tuning for highlights can be optimized by "pixel time" (the amount of time one pixel is exposed to UV light during one exposure cycle) and the number of exposure cycles. To create more flatness of the dot tips, the number of cycles is reduced, while the pixel time is increased accordingly. In some embodiments, the number of cycles may be reduced to only one cycle, such that the polymer is cured completely in one uninterrupted exposure cycle. In this case, the pixel time is equivalent to the complete exposure time. For more roundness of the dot tips (e.g. more like the cross-sectional geometry depicted in FIG. 6A), the exposure is divided into more exposure cycles, each having relatively shorter pixel time.

An exemplary configuration of an exemplary system with a relatively wider aperture is depicted in Fig. 2. For a plate 200 in the position shown, location 201a shows the starting rest location of the UV source before stating an exposure cycle, and location 201b shows the ending rest position of the UV source after an exposure pass in direction of arrow 202 is completed. Dimension C indicates the total length of the flatbed required to accommodate the plate and both the starting rest and ending rest positions of the linear source.

FIG. 2 illustrates a possible disadvantage of a UV source having a total length (e.g. dimension A in the source depicted in FIG. 2) of the exposure apparatus that is relatively larger than in prior art systems (such as that depicted in FIG. 1). Plates typically used in the Esko 5080 system have a length L (in the movement direction of the source) of 203 cm. To foster identical exposure conditions for all portions of the plate, the starting rest position of the source - the position from which the source starts prior to movement in the movement direction during an exposure step (position 201a depicted in FIG. 2) -- does not overlap the plate: i.e., light from the activated source in the starting rest position does not illuminate the plate. Likewise, the ending rest position of the source - the position at which the source ends the pass in the movement direction, and from which it typically reverses direction and traverses back to the starting rest position (position 201b in FIG. 2) - also does not overlap the plate.

A system embodiment having a linear UV source with an aperture of 96x130 cm is significantly longer in the C dimension as compared to the prior art embodiment system with a 16 x 130 cm UV source, and consequently has a greater footprint. For example, for a UV source having a length of about 1 meter curing a plate of about 2 meters, the dimension C would need to be at least about 4 m, and allowing for additional length to accommodate the system housing, the overall length may easily reach 4.5 m.

In order to reduce the footprint, in one embodiment, the collective linear UV source may be divided into a multitude of smaller subset linear sources mounted together, e.g., on a carriage. The subset linear sources are configured to be controlled independently from one another in a way that mimics movement of the collective linear source by turning on an increasing number of subset linear sources.

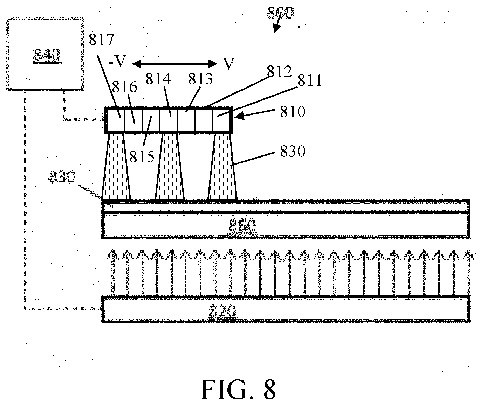

Figure 8 of U.S. Pat. No. 10,732,507 titled PROCESS AND APPARATUS FOR CONTROLLED EXPOSURE OF FLEXOGRAPHIC PRINTING PLATES AND ADJUSTING THE FLOOR THEREOF, assigned to the assignee of the present invention, depicts a UV light source having an area extending across the full area of a plate. The subject source comprises several individually controllable sources that can be controlled in a way that mimics relative motion. One disadvantage of such an embodiment, which covers the full area of the plate, is that the device needs significantly more control circuits and LEDs compared to a device that covers only a portion of the plate, which makes the device more expensive.

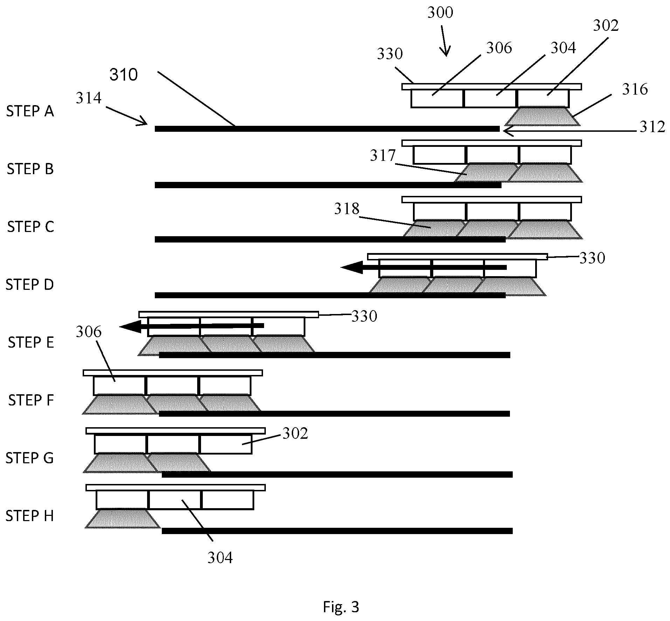

Fig. 3, STEP A- STEP C depicts an example of the starting sequence of an exposure step using a collective linear source 300 (e.g. mounted on a carriage 330) comprising three independent subset UV linear sources 302, 304, 306. In the arrangement as depicted, the starting rest position (the location in STEPS A-C) and ending rest position (the location in STEPS F-H) of carriage 330 overlap the respective end of the plate. For example, in the starting rest position shown in FIG. 3, STEPS A-C, the dimension of the carriage 330 in the movement direction overlaps a first end 312 of the polymer plate 310. As depicted, subset source 302 is located next to, but not overlapping, the first end of the plate in the starting rest position of the carriage (i.e. when activated with the head in the starting rest position, illumination from source 302 does not hit the plate), while the other subset sources 304, 306 are positioned over the plate (i.e. when activated with the head in the starting rest position, illumination from sources 304 and 306 falls on the plate). For simplification, only three subset sources are depicted in Fig. 3, but the invention is not limited to any particular number of subset sources. In general, the more linear subset sources per unit width, the smoother the virtual movement of the collective source created by sequentially activating adjacent subset sources, as is next explained.

As depicted in FIG. 3, STEPS A-C, virtual relative movement is created by activating the subset sources in a sequence that mimics movement of the carriage. In the exemplary embodiment as depicted, subset source 302 is activated first, as depicted by the presence of illumination field 316 in STEP A, then source 304 is activated as depicted by the presence of illumination field 317 in STEP B, then source 306 is activated as depicted by the presence of illumination field 318 in STEP C.

After all subset sources 302, 304, 306 have been activated, carriage 330 starts moving along the polymer plate toward the second end 314 of the plate as depicted by the successive positions of the carriage and sources mounted thereto in Fig. 3, STEP D and STEP E. When source 306 has crossed the second end 314 of the polymer plate, the movement of the carriage stops and the UV light sources are turned off in the sequence 306 → 304 → 302, thus mimicking further movement, as depicted in FIG. 3, STEP F → STEP G → STEP H.

Another advantage of embodiments of the invention comprising a multiple linear UV source system is reduced thermal stress for the polymer plates as compared to prior art systems. As the peak intensity is lower and the total energy is distributed over a wider plate area, temperatures in the plate will not climb as high in embodiments of the system as described herein, as compared to a UV system with a higher power concentration.

### On off patterns with multiple light sources

U.S. Pat. No. 8,820,234 (the '234 Patent), titled CURING OF PHOTO-CURABLE PRINTING PLATES WITH FLAT TOPS OR ROUND TOPS BY VARIABLE SPEED EXPOSURE, assigned to the assignee of the present application, discloses that a drum exposure system can be configured to create round top dots on standard, non-ITP plates when the drum spins fast enough (e.g. in a range of 200-800 RPM) and configured to create flat top dots when the drum spins comparatively very slowly. The slowest speed may be achieved, e.g., when the drum makes only a single revolution for providing complete exposure of the plate on the drum. In other words, the repetition speed of UV light exposure varies the number of exposure cycles and allows modification of the dot tips on a polymer plate when the total exposure time remains the same for both modes of operation.

In a flatbed system, the maximum repetition rate is usually much lower, because the speed of the UV source movement is limited to only a few cm/s. Therefore, round top dots have traditionally only been produced by lowering the intensity of the UV light, which causes an increase in the total exposure time.

Another aspect of the invention is to tailor the geometry of the dot tips ultimately resolving from the plate making process from a flat top shape towards a more round top shape by switching on fewer than all (e.g. only every second or third) subset source during exposure, while the collective source moves along one dimension of the polymer plate.

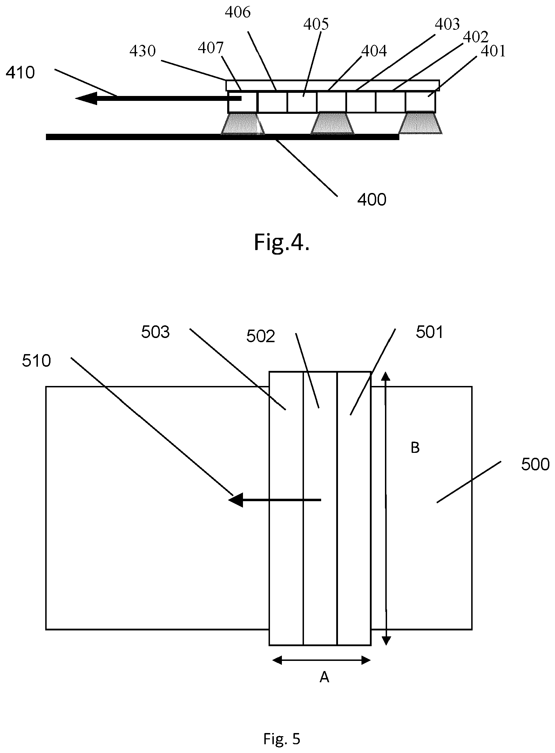

Fig.4 depicts such a configuration having a series of seven UV sources 401 - 407, in which only the subset linear sources 401, 404 and 407 are activated, while the other subset linear sources 402,403, 405 and 406 are deactivated. All subset linear sources are mounted on a carriage that traverses along the dimension L of the polymer plate. Preferably, in this mode of operation, the respective subset linear sources are activated in the pattern as depicted when the carriage is moving in the direction of arrow 410 (not in the direction opposite of arrow 410). The illumination pattern in the starting rest position and in the ending rest position depends on the overall layout of the system, as it is further discussed below. Depending on the desired geometry of the dot tips, alternatively, four sources (e.g. 401, 403, 405, and 407 in the position of the carriage shown) may be activated, or only two sources (e.g. 401 and 407 in the position of the carriage shown) may be ultimately activated to create dot tips that are relatively rounder than the flat top dot structures that would result if all of sources 401-407 inclusive are ultimately activated. Of course, the foregoing 7-source system is only exemplary, and more or fewer sources may be provided, offering different illumination pattern variations.

In one example, the system may have an overall layout similar to that depicted in FIG. 2, in which there is no need to cause sequential activation and deactivation to create virtual relative movement of the carriage. In another embodiment, for overall space considerations, just as discussed above with respect to the arrangement in FIG. 3, the sequence of illuminating the respective subset sources may be configured to provide virtual movement that mimics movement of the carriage, so that in the starting rest and ending rest positions, the carriage can be positioned with some of the subset sources overlapping the plate. For example, the position of the carriage depicted in FIG. 4 may be the starting rest position of the carriage, in which subset sources 402-407 overlap the plate, and only subset source 401 does not overlap the plate. Prior to the configuration in which 401, 404 and 407 are illuminated as depicted in FIG. 4, carriage 430 may remain in the starting rest position, and the sources may be sequentially illuminated in the following starting rest position stepwise sequence:
1) No sources illuminated
2) 401 only illuminated (although illumination from 401 may not hit the plate in the starting rest position, akin to providing illumination in the B direction that extends past the edge of the plate)
3) 402 only illuminated
4) 403 only illuminated
5) 404 and 401 illuminated
6) 405 and 402 illuminated
7) 406 and 403 illuminated
8) 401, 404, and 407 illuminated

Then, the carriage may move along the direction of arrow 410. At the other end of the plate, deactivation of the subset sources may similarly create virtual movement in the following ending rest position stepwise sequence:
1) 401, 404, and 407 illuminated
2) 402 and 405 illuminated
3) 403 and 406 illuminated
4) 404 and 407 illuminated
5) 405 only illuminated
6) 406 only illuminated
7) 407 only illuminated (optional, depending if any of the illumination from 401 hits the plate in the resting position)
8) No sources illuminated

From the ending rest position, the carriage preferably traverses with no sources illuminated back to the starting position. However, in some embodiments, an opposite illumination sequence may be employed and an exposure pass may commence in the direction opposite arrow 410 back to the starting rest position, at which point the illumination sequence follows the opposite of the starting illumination sequence noted above for the starting rest position. Typically, and preferably, illumination occurs only in one direction, not in both directions, so that for any one coordinate on the plate, the time between receiving first and second passes of illumination is the same. Otherwise, the end of the plate where the carriage reverses receives its first and second doses of radiation in quick succession, whereas the starting end of the plate receives its first and second doses of radiation spread much further apart in time (although if another pass is made, the starting end receives its second and third doses in quick succession, whereas the opposite end receives those doses more spread out). In embodiments in which these time differences are immaterial to overall plate quality, making passes in both directions will provide faster throughput, but in most cases, providing illumination in only one movement direction is preferred for quality reasons.

It should be understood that relative size and number of the linear subsources as discussed above is only exemplary, for illustration. In actual operation, more independently controllable subsources may be provided, with the activated regions comprising more than one activated source.

### Different intensities

In another aspect of the invention, the first UV subsource(s) illuminating the plate in the direction of the movement during exposure (i.e. the leading edge source(s)) have a higher irradiance than the subsequently illuminating sources. This allows curing of dots with sharper edges at the top, resulting in an even flatter top shape without equipping all UV sources with high UV power. In this configuration, the output power of each source is fixed to a predetermined level. Such an embodiment is depicted in Fig. 5. The UV sources 501, 502 and 503 cover the plate 500 completely in dimension B and move together on carriage 504 in the direction of arrow 510. The first UV source 503 in direction of the movement 510 has a higher irradiance than the subsequent UV sources 502 and 501. The number of sources in Fig. 5 is just an example, and this aspect of the invention is not limited to any particular number of sources. More or fewer relatively lower intensity linear subsources, as well as the more or fewer relatively high intensity sources may be provided.

Another method and system for modifying intensity is to change the distance between a number of sources of identical intensity while all sources are moved together in direction of the relative motion. When the sources are in relatively closer proximity, the UV power is concentrated on a relatively smaller area of the polymer plate, whereas when the sources are further apart, the same amount of UV power is spread over a wider area. As described in the '234 Patent, when the speed of movement is high enough, even gaps between the sources can be integrated to an average irradiance. The '234 Patent mentions that this will happen at rotation speeds higher than 120 RPM. Thus, when movement is sufficiently fast such that gaps between the sources last for less than 0.5 seconds, most polymer types will "see" an average irradiance.

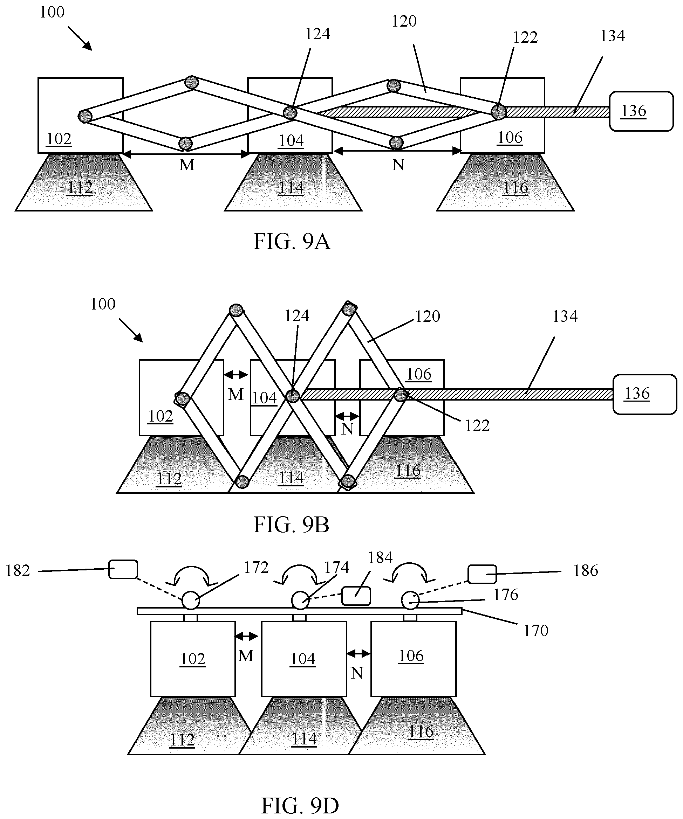

An embodiment applying the principles of the foregoing is depicted in FIGs. 9A and 9B. As depicted in FIG. 9A, system 100 comprises three linear subsources 102, 104, 106, each emitting a respective illumination field 112, 114, 116. The sources are connected by a linkage 120, such as the scissor mechanism linkage depicted in FIGs. 9A and 9B. In the configuration shown in FIG. 9A, linkage 120 is depicted in an expanded configuration, in which the linear subsources 102, 104, 106 and their respective illumination fields are relatively further spaced apart than in the relatively compressed configuration of the linkage 120 depicted in FIG. 9B. Although three such subsources are so connected as depicted in FIGS. 9A and 9B, fewer or more such sources may be so connected for providing configurations with different intensities. Furthermore, although depicted with a single exemplary linkage connecting three adjacent subsources, it should be understood that each set of two adjacent subsources may be connected by an independently controllable linkage. It should be further understood that although discussed in the context of providing a greater intensity at the leading edge of the overall radiation field, adjustable spacing may be used for providing different intensities in any portion of the radiation field, such as in the trailing edge.

Ideally, the relative movement between the plate and the carriage, and the movement of the linear subsources relative to one another are independent of one another. Various mechanisms for causing relative movement between the plate and the carrier are well known and are not discussed in detail herein.

Linkage 120 may be controlled by a controller (which may be the same controller that controls other aspects of the system) that causes the linkage to expand or contract, e.g. by causing node 122 to move relative to node 124, such as using a linear actuator. For the scissor mechanism linkage 120 depicted in FIG. 9A, the linear actuator may comprise a lead screw 134 driven by motor 136 that pushes nodes 122 and 124 apart when the motor rotates in one rotation direction, and brings the nodes together when the motor rotates the opposite rotation direction (e.g. using a mechanism generally known for employment in a car jack). The invention is not limited to any particular type of linear actuator.

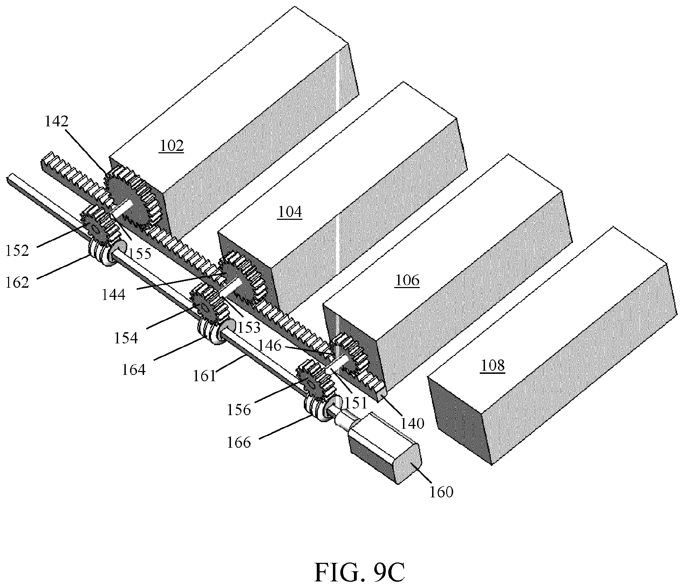

Another mechanism for moving the sources relative to one another is depicted schematically in FIG. 9C. Gear wheels 142, 144, 146, each fixed to respective linear subsource, may be in contact with a gear rack 140. In one embodiment, each gear wheel may have a different number of teeth (e.g. 30 teeth for gear wheel 142; 20 teeth for gear wheel 144; 10 teeth for gear wheel 146). A suitable mechanism causes each gear wheel 142, 144, 146 to rotate in unison a same degree of rotation, such that the different number of teeth on each gear causes a different absolute amount of movement of each linear subsource, which in turn translates to the desired amount of spacing between adjacent linear subsources. An exemplary mechanism for causing the gear wheels to experience a common degree of rotation may include worm gears 162, 164, 166 slidably disposed on square cross-section shaft 161 attached to motor 160, which drive worm-driven gears 152, 154, 156, respectively. Each worm-driven gear 152, 154, 156 is the same size and has the same number of teeth. Each worm-driven gear 152, 154, 156 is respectively disposed on a common shaft 151, 153, 155 with one of respective gear wheels 142, 144, 146. The worm gears and toothed gears are typically contained in a housing and disposed on bearings, neither of which are shown to reduce clutter in the figure, but would be well understood by those of skill in the art. In this arrangement, the gearing ratios of gears 142, 144, 146 may be defined to ensure the spacing remains equal between each adjacent pair of adjacent subsources, even as the size of the space changes (e.g. M = N, even though both M and N may vary within a predetermined range of values). In other embodiments, the gearing may be defined to cause some spacing to be different than other spacing. Fewer than all of the subsources may have adjustable spacing, such as is depicted in FIG. 9C, in which only linear subsources 102, 104 and 106 have adjustable spacing, (e.g. to implement embodiments in which the leading edge intensity is relative greater than trailing intensity as described above). In other embodiments, all of the sources may have adjustable spacing therebetween. In other embodiments, a chain drive comprising a chain (not shown) attached to a motor (not shown) may drive chain-driven gears (not shown) disposed in place of the worm-driven gears.

Embodiments with interconnected sources moveable by a common driver are not limited to rack and gear or linear-actuated linkages, and may comprise any mechanical systems known in the art for causing simultaneous movement of multiple elements.

In other implementations, the individual subsources may be independently positionable, such as in the system depicted in FIG. 9D, in which gear wheels 172, 174, 176 attached to each subsource 102, 104, 106 have a same number of teeth. Each is connected to a dedicated drive motor 182, 184, 186, such as a stepper motor. Changes in position on stationary rack 170 are controlled by the number and direction of steps instructed by the controller for each stepper motor, which translates to the desired rotation of each gear. In such an implementation, the spaces M and N may not be equal in some configurations, e.g. two sources may be moved closer together for some implementations, and three sources moved closer together in other implementations. This implementation is not limited to the use of stepper motors, and any individual independent positioners may be used. Furthermore, although a system with individual stepper motors is flexible enough to provide independent control, the motors may also be synchronized to provide synchronized movement akin to that provided by the linkage or rack systems described herein.

Finally, the use of adjustable spacing between sources may be applied to other concepts as discussed herein. For example, instead of selectively disabling sources, as disclosed in FIG. 4, the spacing between activated sources may be provided by adjusting spacing between the subset sources, rather than turning off one or more of the sources. As another example, light coverage over a wider aperture may be provided while minimizing the demands for greater "real estate" as depicted in FIG. 2, by providing a collective source having a compressed spacing configuration of linear sources in the resting position, wherein the spacing between sources is first expanded to create actual movement of the linear subsources over the plate, and then once a predetermined spacing of all sources is reached, the carriage moves while maintaining the predetermined spacing. At the opposite end of the pass, the spacing is collapsed to complete the motion of the sources. In particular, the embodiment disclosed in FIG. 9D, in which each source is configured to move independently of one another, may be well suited for this implementation. A combination of adjustable spacing and selectively activating and deactivating sources may be used.

It should be understood that in a system configured for both round top and flat top operation, the leading edge source(s) may be controllable between multiple power settings, preferably optimized for two settings - high and low. In the low setting, such as may be optimized for creating round top dots, the leading edge source(s) may be configured with the same output power as the remaining sources. In the high setting, such as may be optimized for creating flat top dots, the leading edge source(s) may be configured to run at a relatively higher output power than the remaining sources, for the reasons described above. With preferably only two settings, the linear source can be balanced and optimized for each setting, and the controller programmed accordingly.

In embodiments in which the system is configured to illuminate the plate in both directions of relative movement, the edge linear subset source(s) on both edges may be configured to operate in the high power setting when on the leading edge of the movement direction, and to operate in the low power setting when on the trailing edge of the movement direction.

### Back exposure

Back exposure may be applied in the embodiments as described herein either by exposing the entire plate from the back side before front exposure starts and/or in between front exposure cycles.

In another embodiment, the back exposure is applied by a UV source that extends along dimension B of the polymer plate, has relative motion in the other dimension L of the plate, and is spaced ahead of the front exposure heads in a way that a precisely defined time delay is achieved between back and front exposure (as described in more detail in U.S. Pat. No. 10,732,5079). This configuration can be applied to systems having a front source that moves only actually, as well as to systems employing virtual movement by switching stationary front sources on and off, or systems having a front source configured to produce a combination of virtual and actual movement. The back exposure source may also be configured for actual movement only, virtual movement only, or a combination thereof, and may be controllable by the same controller as for the front source and for the relative motion.

A schematic of a system 700 including a movable linear back exposure head is depicted in FIG. 7. As depicted, controller 710 controls front linear exposure head 720, comprising linear subgroup sources 722, 724, 726, and controls back exposure head 730. Both the front 720 and back 730 exposure heads are configured for relative movement in the direction V, such as each head being disposed on a moveable carriage (not shown), configured to move relative to substrate 750 on which plate 740 is disposed. Plate 740 comprises a LAMs layer 762, photopolymer layer 741, and a backing layer 742. Substrate 750, and backing layer 742, are transparent (or at least translucent) to the back radiation. Ablated areas 760 in the LAMs layer form a mask that regulates the passage of curing UV light from the radiation sources 722, 724, 726 into the photopolymer layer 741, to form printing dots. While an ablated area 760 is depicted in white relative to non-ablated areas 762 in black in Fig. 7, it should be understood that the opposite color convention may be used in other disclosures, without prejudice. The leading edge of the back radiation source 730 is offset by a distance D from the leading edge of the front radiation source 726, which distance may be adjustable.

A schematic drawing of a system 800 including a stationary, area back exposure head 820 coextensive with both lateral dimensions of plate 830 disposed on UV transparent or translucent substrate 860 in FIG. 8. The individual layers of plate 830 are not shown, but the plate includes at least a mask (which may be a mask created by any method known in the art) for modulating the front exposure from moveable linear front exposure unit 810 that is moveable in both the V and -V directions. Controller 410 may be configured to cause emission from the front exposure unit 810 in only the V direction, or in both the V and -V directions, as described above. As depicted, fewer than all of the individual linear subset sources 811-817 are emitting illumination fields 830 (e.g. only subset sources 811, 814 and 817), in accordance with one of the embodiments as described herein. It should be understood, however, that the configuration shown may be used, and the controller so programmed accordingly, to perform any of the methods and to conform to any of the systems as shown and described herein.

The controller as described herein may be any type of controller known in the art for controlling power to UV LED sources and for controlling relative movement of the plate and the exposure head, such as a programmable controller including a computer processor with access to computer readable memory media programmed with machine readable instructions for causing the controller to operate the exposure system to perform the various methods as discussed herein. While illustrated herein with a moving carriage for the exposure head, it should be understood that the relative movement may also be provided by a system in which the substrate on which the plate is disposed is moveable, and the sources are stationary. The systems, mechanisms, and controllers for creating such relative movement are well known in the art and are not discussed in more detail herein. It should be understood that exposure systems with linear exposure heads and a plurality of subset linear sources may be provided having one, more than one, or all of the functionalities as described herein. While discussed herein in connection with UV LED systems, it should be understood that aspects of the invention are not limited to usefulness only in UV LED systems, and may be practiced in any system using a linear irradiation source at any wavelength for curing a printing plate (or any curable photopolymer target) with actinic radiation.

It should be understood that the systems and methods as described herein may be practiced on a new system created just for the functionalities as described, or prior art systems may be retrofitted with new UV exposure heads and controllers (or existing controllers reconfigured) to practice one or more of the aspects of the invention as described herein. In particular, the functionality of being able to create virtual movement for a UV exposure head having a wider aperture than the head that it replaces, to permit the head to overlap the plate in the resting positions of the head, permits a wider aperture head to be retrofitted into an existing system without having to change the size of the system. The advantages of such a system may also, for new systems, allow customers with prior art systems to replace old systems with new within the same footprint of existing equipment.

## Claims

1. A UV exposure apparatus (700, 800) for curing a flexographic photopolymer printing plate (310, 400, 500, 740, 830), the plate having a first lateral dimension and a second lateral dimension, the UV exposure apparatus comprising:
a substrate (750, 860) configured to receive the plate in a position to receive incident radiation;
a linear front exposure head (300, 720, 810) configured to emit a collective irradiation field toward a front side of the plate disposed on the substrate, the collective irradiation field covering a collective area coextensive with the first lateral dimension of the plate and non-coextensive with the second lateral dimension of the plate, the linear front exposure head comprising a plurality of front UV LED radiation point sources arranged in a plurality of independently controllable linear subgroups (302, 304, 306; 401-407; 501-503; 722, 724, 726; 811-817; 102, 104, 106), each linear subgroup configured to emit a component irradiation field covering a component area coextensive with the first dimension of the plate, non-coextensive with the second dimension of the plate, and less than the collective area of the collective irradiation field;
means for causing relative movement at a movement speed between the printing plate and the linear front exposure head along the second dimension of the plate in one or more front exposure cycles, each front exposure cycle comprising relative movement in a first movement direction across one full second dimension of the plate while at least some of the plurality of front UV LED radiation point sources are activated;
a controller (710, 840) connected to the plurality of radiation sources and to the means for causing relative movement, the controller configured to activate and deactivate the plurality of UV LED radiation point sources and to control exposure of the polymer plate using the movement speed, selective activation and deactivation of the linear subgroups, or a combination thereof to cause the plate to receive an amount of total exposure energy applied to the plate by the linear front exposure head,
wherein the controller is further configured to selectively activate and deactivate the linear subgroups to mimic relative motion of the linear subgroups relative to the plate.

2. The apparatus of claim 1, wherein the plurality of front UV LED radiation point sources have a fixed intensity.

3. The apparatus of claim 1 or claim 2, wherein the controller is configured to control the total exposure energy applied to the plate by the linear front exposure head within a given exposure time by controlling a maximum total number of linear subgroups activated simultaneously; and/or
wherein the controller is configured to distribute the total exposure energy applied to the plate by the linear front exposure head over a plurality of front exposure cycles.

4. The apparatus of any one of claims 1-3, further comprising a back UV exposure source (730, 820) configured to emit radiation toward a back surface of the plate disposed on the substrate, wherein the controller is configured to control the back UV exposure source to apply the back exposure sequentially before a first front exposure cycle, between a pair of sequential front exposure cycles, or a combination thereof; and optionally:
wherein the back exposure source is configured to emit the radiation toward the back surface of the plate in a back irradiation field coextensive with the first lateral dimension of the plate and coextensive with the second lateral dimension of the plate; or
wherein the back exposure source is configured to emit the radiation toward the back surface of the plate in a back irradiation field coextensive with the first lateral dimension of the plate and non- coextensive with the second lateral dimension of the plate, and preferably wherein the back exposure source precedes the front exposure source in the first movement direction and a distance between a leading edge of the front exposure source and a leading edge of the back exposure source is adjustable so that a constant time difference between beginning of back and beginning of front exposure is attainable for a range of movement speeds.

5. The apparatus of any one of claims 1-4, wherein one or more of the linear subgroups positioned adjacent a leading edge of the linear front exposure head comprise UV LED point sources with a higher intensity than corresponding UV LED point sources in the remaining linear subgroups that have a lower intensity; and/or
wherein the one or more of the linear subgroups positioned adjacent a leading edge of the linear front exposure head are controllable between at least the higher intensity and the lower intensity; and/or
wherein the controller is configured to cause emission of the collective irradiation field in only the first movement direction.

6. The apparatus of any one of claims 1-5, wherein the linear front exposure head has a starting rest position and an ending rest position, and in at least one of the starting rest position and the ending rest position, one or more of the linear subgroups are positioned to illuminate a portion of the plate when in an activated state.

7. The apparatus of claim 6, wherein the controller is configured to selectively activate and deactivate the linear subgroups in a first sequence to mimic relative motion of the linear subgroups relative to the plate in a first part of at least one exposure cycle in which the linear front exposure head is in the starting rest position, cause actual relative motion in the first movement direction in a second part of the at least one exposure cycle, and selectively activate and deactivate the linear subgroups in a second sequence to mimic relative motion of the linear subgroups relative to the plate with the linear front exposure head in the ending rest position in a third part of the at least one exposure cycle; and/or
wherein the controller is configured to cause the linear front exposure head to return from the ending rest position to the starting rest position in a second movement direction opposite the first movement direction with none of the linear subgroups activated; and/or
wherein the controller is configured to cause a third sequence of selective activation and deactivation of the linear subgroups in a fourth part of the at least one exposure cycle with the linear front exposure head in the ending rest position, cause actual relative motion in a second movement direction opposite the first movement direction in a fifth part of the at least one exposure cycle, and cause a fourth sequence of selective activation and deactivation of the linear subgroups in a sixth part of the at least one exposure cycle with the linear front exposure head in the starting rest position.

8. The apparatus of claim 7, wherein the controller is configured to activate all of the linear subgroups during the second part of the at least one exposure cycle, or
wherein the controller is configured to activate fewer than all of the linear subgroups during the second part of the at least one exposure cycle.

9. The apparatus of any one of claims 1-8, wherein the controller is configured to activate fewer than all of the linear subgroups during a relative motion portion of the at least one exposure cycle.

10. The apparatus of any one of claims 1 to 9, wherein at least one adjacent pair of the one or more of the linear subsources are spaced apart from one another with a spacing that is adjustable; and/or
wherein multiple adjacent pairs of linear subsources have an adjustable spacing between them, and are connected to one another with a mechanism configured to adjust the spacing between multiple adjacent pairs using a single driver, or wherein multiple adjacent pairs of linear subsources have an adjustable spacing between them, and each linear subsource in the multiple adjacent pairs is connected to an independently controllable positioner.

11. The apparatus of claim 10, wherein the controller is configured to regulate intensity of exposure by adjusting the spacing between two or more subsources.

12. The apparatus of any one of claims 1 to 11, wherein the controller is configured to cause exposure of a portion of the plate in the first movement direction by causing a first activated linear subsource to move in the first movement direction relative to a second linear subsource,
wherein optionally the controller is configured to cause the first activated linear subsource to move relative to the second linear subsource at a time when the second linear subsource is not positioned over the plate.

13. A method for curing a flexographic photopolymer printing plate (310, 400, 500, 740, 830) having a first lateral dimension and a second lateral dimension, the method comprising:
disposing the printing plate in a position to receive incident radiation;
emitting UV radiation with a linear front exposure head (300, 720, 810) configured to emit a collective irradiation field toward a front side of the plate, the collective irradiation field covering a collective area coextensive with the first lateral dimension of the plate and non-coextensive with the second lateral dimension of the plate, the linear front exposure head comprising a plurality of front UV LED radiation point sources arranged in a plurality of independently controllable linear subgroups (302, 304, 306; 401-407; 501-503; 722, 724, 726; 811-817; 102, 104, 106), each linear subgroup configured to emit a component irradiation field covering a component area coextensive with the first dimension of the plate, non-coextensive with the second dimension of the plate, and less than the collective area of the collective irradiation field;
moving the printing plate and the linear front exposure head relative to one another at a movement speed along the second dimension of the plate in one or more front exposure cycles, each front exposure cycle comprising relative movement in a first movement direction across one full second dimension of the plate while at least some of the plurality of front UV LED radiation point sources are emitting UV radiation;
controlling exposure of the polymer plate using a combination of the movement speed and selective activation and deactivation of the linear subgroups, thereby causing the plate to receive an amount of total exposure energy applied to the plate by the linear front exposure head, wherein the controlling comprises selectively activating and deactivating the linear subgroups to mimic relative motion of the linear subgroups relative to the plate.

14. The method of claim 13, comprising controlling printing dot top geometry by controlling a maximum total number of linear subgroups activated simultaneously during the one or more front exposure cycles.

## Patentansprüche

1. Eine UV-Belichtungsvorrichtung (700, 800) zum Härten einer flexographischen Photopolymer-Druckplatte (310, 400, 500, 740, 830), wobei die Platte eine erste laterale Abmessung und eine zweite laterale Abmessung aufweist, wobei die UV-Belichtungsvorrichtung Folgendes umfasst:
ein Substrat (750, 860), das konfiguriert ist, um die Platte in einer Position aufzunehmen, um einfallende Strahlung zu empfangen;
einen linearen Frontbelichtungskopf (300, 720, 810), der konfiguriert ist, um ein kollektives Bestrahlungsfeld in Richtung einer Vorderseite der auf dem Substrat angeordneten Platte zu emittieren, wobei das kollektive Bestrahlungsfeld eine kollektive Fläche abdeckt, die mit der ersten lateralen Abmessung der Platte koextensiv ist und mit der zweiten lateralen Abmessung der Platte nicht koextensiv ist, wobei der lineare Frontbelichtungskopf eine Vielzahl von frontseitigen UV-LED-Strahlungs-Punktquellen umfasst, die in einer Vielzahl von unabhängig steuerbaren linearen Untergruppen (302, 304, 306; 401-407; 501-503; 722, 724, 726; 811-817; 102, 104, 106) angeordnet sind, wobei jede lineare Untergruppe konfiguriert ist, um ein Komponentenbestrahlungsfeld zu emittieren, das eine Komponentenfläche abdeckt, die mit der ersten Abmessung der Platte koextensiv ist, mit der zweiten Abmessung der Platte nicht koextensiv ist und kleiner ist als die kollektive Fläche des kollektiven Bestrahlungsfeldes;
Mittel zum Bewirken einer Relativbewegung mit einer Bewegungsgeschwindigkeit zwischen der Druckplatte und dem linearen Frontbelichtungskopf entlang der zweiten Abmessung der Platte in einem oder mehreren Frontbelichtungszyklen, wobei jeder Frontbelichtungszyklus eine Relativbewegung in einer ersten Bewegungsrichtung über eine volle zweite Abmessung der Platte umfasst, während zumindest einige der Vielzahl von frontseitigen UV-LED-Strahlungspunktquellen aktiviert sind;
eine Steuerung (710, 840), die mit der Vielzahl von Strahlungsquellen und mit den Mitteln zum Bewirken einer Relativbewegung verbunden ist, wobei die Steuerung konfiguriert ist, um die Vielzahl von UV-LED-Strahlungspunktquellen zu aktivieren und zu deaktivieren und um die Belichtung der Polymerplatte zu steuern, unter Verwendung der Bewegungsgeschwindigkeit, eine selektiven Aktivierung und Deaktivierung der linearen Untergruppen oder eine Kombination davon, um zu bewirken, dass die Platte eine Menge an Gesamtbelichtungsenergie erhält, die vom linearen Frontbelichtungskopf auf die Platte aufgebracht wird,
wobei die Steuerung ferner dazu konfiguriert ist, die linearen Untergruppen selektiv zu aktivieren und zu deaktivieren, um eine relative Bewegung der linearen Untergruppen relativ zur Platte nachzuahmen.

2. Die Vorrichtung nach Anspruch 1, wobei die Vielzahl von frontseitigen UV-LED-Strahlungspunktquellen eine feste Intensität aufweist.

3. Die Vorrichtung nach Anspruch 1 oder Anspruch 2, wobei die Steuerung konfiguriert ist, um die vom linearen Frontbelichtungskopf auf die Platte aufgebrachte Gesamtbelichtungsenergie innerhalb einer vorgegebenen Belichtungszeit durch Steuern einer maximalen Gesamtzahl von gleichzeitig aktivierten linearen Untergruppen zu steuern; und/oder
wobei die Steuerung konfiguriert ist, um die vom linearen Frontbelichtungskopf auf die Platte aufgebrachte Gesamtbelichtungsenergie über eine Vielzahl von Frontbelichtungszyklen zu verteilen.

4. Die Vorrichtung nach irgendeinem der Ansprüche von 1 bis 3, ferner umfassend eine rückseitige UV-Belichtungsquelle (730, 820), die konfiguriert ist, um Strahlung in Richtung einer Rückseite der auf dem Substrat angeordneten Platte zu emittieren, wobei die Steuerung konfiguriert ist, um die rückseitige UV-Belichtungsquelle so zu steuern, dass die Rückseitenbelichtung sequenziell vor einem ersten Frontbelichtungszyklus, zwischen einem Paar aufeinanderfolgender Frontbelichtungszyklen oder einer Kombination davon angewendet wird; und optional:
wobei die rückseitige Belichtungsquelle konfiguriert ist, um die Strahlung in Richtung der Rückseite der Platte in einem rückseitigen Bestrahlungsfeld zu emittieren, das mit der ersten lateralen Abmessung der Platte koextensiv ist und mit der zweiten lateralen Abmessung der Platte koextensiv ist; oder
wobei die rückseitige Belichtungsquelle konfiguriert ist, um die Strahlung in Richtung der Rückseite der Platte in einem rückseitigen Bestrahlungsfeld zu emittieren, das mit der ersten lateralen Abmessung der Platte koextensiv ist und mit der zweiten lateralen Abmessung der Platte nichtkoextensiv ist,
und vorzugsweise wobei die Rückbelichtungsquelle der Frontbelichtungsquelle in der ersten Bewegungsrichtung vorausgeht und ein Abstand zwischen einer Vorderkante der Frontbelichtungsquelle und einer Vorderkante der Rückbelichtungsquelle einstellbar ist, sodass eine konstante Zeitdifferenz zwischen dem Beginn der Rückbelichtung und dem Beginn der Frontbelichtung für einen Bereich von Bewegungsgeschwindigkeiten erreichbar ist.

5. Die Vorrichtung nach irgendeinem der Ansprüche von 1 bis 4, wobei eine oder mehrere der linearen Untergruppen, die benachbart zu einer Vorderkante des linearen Frontbelichtungskopfes positioniert sind, UV-LED-Punktquellen mit einer höheren Intensität umfassen als entsprechende UV-LED-Punktquellen in den übrigen linearen Untergruppen, die eine geringere Intensität aufweisen; und/oder
wobei die eine oder mehreren der linearen Untergruppen, die benachbart zu einer Vorderkante des linearen Frontbelichtungskopfes positioniert sind, zwischen zumindest der höheren Intensität und der geringeren Intensität steuerbar sind; und/oder
wobei die Steuerung konfiguriert ist, um die Emission des kollektiven Bestrahlungsfeldes nur in der ersten Bewegungsrichtung zu bewirken.

6. Die Vorrichtung nach irgendeinem der Ansprüche von 1 bis 5, wobei der lineare Frontbelichtungskopf eine Start-Ruhestellung und eine End-Ruhestellung aufweist und in mindestens einer von der Start-Ruhestellung und der End-Ruhestellung eine oder mehrere der linearen Untergruppen so positioniert sind, dass sie einen Abschnitt der Platte beleuchten, wenn sie sich in einem aktivierten Zustand befinden.

7. Die Vorrichtung nach Anspruch 6, wobei die Steuerung konfiguriert ist, um die linearen Untergruppen in einer ersten Sequenz selektiv zu aktivieren und zu deaktivieren, um eine relative Bewegung der linearen Untergruppen relativ zur Platte in einem ersten Teil von mindestens einem Belichtungszyklus nachzuahmen, in dem sich der lineare Frontbelichtungskopf in der Start-Ruhestellung befindet, eine tatsächliche relative Bewegung in der ersten Bewegungsrichtung in einem zweiten Teil des mindestens einen Belichtungszyklus zu bewirken, und die linearen Untergruppen in einer zweiten Sequenz selektiv zu aktivieren und zu deaktivieren, um die relative Bewegung der linearen Untergruppen relativ zur Platte mit dem linearen Frontbelichtungskopf in der End-Ruhestellung in einem dritten Teil des mindestens einen Belichtungszyklus nachzuahmen; und/oder
wobei die Steuerung konfiguriert ist, um zu bewirken, dass der lineare Frontbelichtungskopf aus der End-Ruhestellung in einer zur ersten Bewegungsrichtung entgegengesetzten zweiten Bewegungsrichtung in die Start-Ruhestellung zurückkehrt, ohne dass eine der linearen Untergruppen aktiviert ist; und/oder
wobei die Steuerung konfiguriert ist, um eine dritte Sequenz selektiver Aktivierung und Deaktivierung der linearen Untergruppen in einem vierten Teil des mindestens einen Belichtungszyklus mit dem linearen Frontbelichtungskopf in der End-Ruhelage zu bewirken, um eine tatsächliche Relativbewegung in einer zur ersten Bewegungsrichtung entgegengesetzten zweiten Bewegungsrichtung in einem fünften Teil des mindestens einen Belichtungszyklus zu bewirken, und um eine vierte Sequenz selektiver Aktivierung und Deaktivierung der linearen Untergruppen in einem sechsten Teil des mindestens einen Belichtungszyklus mit dem linearen Frontbelichtungskopf in der Start-Ruhestellung zu bewirken.

8. Die Vorrichtung nach Anspruch 7, wobei die Steuerung konfiguriert ist, um alle linearen Untergruppen während des zweiten Teils des mindestens einen Belichtungszyklus zu aktivieren, oder
wobei die Steuerung konfiguriert ist, um weniger als alle linearen Untergruppen während des zweiten Teils des mindestens einen Belichtungszyklus zu aktivieren.

9. Die Vorrichtung nach irgendeinem der Ansprüche von 1 bis 8, wobei die Steuerung konfiguriert ist, um weniger als alle linearen Untergruppen während eines Abschnitts der Relativbewegung des mindestens einen Belichtungszyklus zu aktivieren.

10. Die Vorrichtung nach irgendeinem der Ansprüche von 1 bis 9, wobei mindestens ein benachbartes Paar der einen oder mehreren linearen Unterquellen voneinander beabstandet sind, wobei der Abstand einstellbar ist; und/oder
wobei mehrere benachbarte Paare linearer Unterquellen einen einstellbaren Abstand voneinander aufweisen und miteinander durch einen Mechanismus verbunden sind, der konfiguriert ist, um den Abstand zwischen mehreren benachbarten Paaren unter Verwendung eines einzigen Antriebs einzustellen, oder wobei mehrere benachbarte Paare linearer Unterquellen einen einstellbaren Abstand voneinander aufweisen und jede lineare Unterquelle in den mehreren benachbarten Paaren mit einem unabhängig steuerbaren Positionierer verbunden ist.

11. Die Vorrichtung nach Anspruch 10, wobei die Steuerung konfiguriert ist, um die Intensität der Belichtung durch Einstellen des Abstands zwischen zwei oder mehr Unterquellen zu regulieren.

12. Die Vorrichtung nach irgendeinem der Ansprüche von 1 bis 11, wobei die Steuerung konfiguriert ist, um eine Belichtung eines Abschnitts der Platte in der ersten Bewegungsrichtung zu bewirken, indem eine erste aktivierte lineare Unterquelle veranlasst wird, sich in der ersten Bewegungsrichtung relativ zu einer zweiten linearen Unterquelle zu bewegen,
wobei optional die Steuerung konfiguriert ist, um die erste aktivierte lineare Unterquelle zu veranlassen, sich relativ zur zweiten linearen Unterquelle zu einem Zeitpunkt zu bewegen, zu dem die zweite lineare Unterquelle nicht über der Platte positioniert ist.

13. Ein Verfahren zum Aushärten einer flexographischen Photopolymer-Druckplatte (310, 400, 500, 740, 830) mit einer ersten lateralen Abmessung und einer zweiten lateralen Abmessung, wobei das Verfahren Folgendes umfasst:
Anordnen der Druckplatte in einer Position, um einfallende Strahlung zu empfangen;
Emittieren von UV-Strahlung mit einem linearen Frontbelichtungskopf (300, 720, 810), der konfiguriert ist, um ein kollektives Bestrahlungsfeld in Richtung einer Vorderseite der Platte zu emittieren, wobei das kollektive Bestrahlungsfeld eine kollektive Fläche abdeckt, die mit der ersten lateralen Abmessung der Platte koextensiv ist und mit der zweiten lateralen Abmessung der Platte nicht koextensiv ist, wobei der lineare Frontbelichtungskopf eine Vielzahl von frontseitigen UV-LED-Strahlungs-Punktquellen umfasst, die in einer Vielzahl von unabhängig steuerbaren linearen Untergruppen (302, 304, 306; 401-407; 501-503; 722, 724, 726; 811-817; 102, 104, 106) angeordnet sind, wobei jede lineare Untergruppe konfiguriert ist, um ein Komponentenbestrahlungsfeld zu emittieren, das eine Komponentenfläche abdeckt, die mit der ersten Abmessung der Platte koextensiv ist, mit der zweiten Abmessung der Platte nicht koextensiv ist und kleiner ist als die kollektive Fläche des kollektiven Bestrahlungsfeldes;
Bewegen der Druckplatte und des linearen Frontbelichtungskopfes relativ zueinander mit einer Bewegungsgeschwindigkeit entlang der zweiten Abmessung der Platte in einem oder mehreren Frontbelichtungszyklen, wobei jeder Frontbelichtungszyklus eine Relativbewegung in einer ersten Bewegungsrichtung über eine volle zweite Abmessung der Platte umfasst, während zumindest einige der Vielzahl von frontseitigen UV-LED-Strahlungspunktquellen UV-Strahlung emittieren;
Steuern der Belichtung der Polymerplatte unter Verwendung einer Kombination aus der Bewegungsgeschwindigkeit und der selektiven Aktivierung und Deaktivierung der linearen Untergruppen, wodurch die Platte eine Menge an Gesamtbelichtungsenergie erhält, die vom linearen Frontbelichtungskopf auf die Platte aufgebracht wird, wobei das Steuern das selektive Aktivieren und Deaktivieren der linearen Untergruppen umfasst, um eine relative Bewegung der linearen Untergruppen relativ zur Platte nachzuahmen.

14. Das Verfahren nach Anspruch 13, umfassend das Steuern der Geometrie der Druckpunktspitzen (*printing dot top geometry*) durch Steuern einer maximalen Gesamtzahl linearer Untergruppen, die während des einen oder der mehreren vorderen Belichtungszyklen gleichzeitig aktiviert werden.

## Revendications

1. Un appareil d'exposition aux UV (700, 800) pour durcir une plaque d'impression photopolymère flexographique (310, 400, 500, 740, 830), la plaque présentant une première dimension latérale et une deuxième dimension latérale, l'appareil d'exposition aux UV comprenant :
un substrat (750, 860) configuré pour recevoir la plaque dans une position permettant de recevoir un rayonnement incident ;
une tête d'exposition frontale linéaire (300, 720, 810) configurée pour émettre un champ d'irradiation collectif vers une face avant de la plaque disposée sur le substrat, le champ d'irradiation collectif couvrant une surface collective coextensive avec la première dimension latérale de la plaque et non coextensive avec la deuxième dimension latérale de la plaque, la tête d'exposition frontale linéaire comprenant une pluralité de sources ponctuelles de rayonnement UV LED frontales agencées en une pluralité de sous-groupes linéaires commandables indépendamment (302, 304, 306 ; 401-407 ; 501-503 ; 722, 724, 726 ; 811-817 ; 102, 104, 106), chaque sous-groupe linéaire étant configuré pour émettre un champ d'irradiation de composante couvrant une surface de composante coextensive avec la première dimension de la plaque, non coextensive avec la deuxième dimension de la plaque, et inférieure à la surface collective du champ d'irradiation collectif ;
des moyens destinés à provoquer un mouvement relatif à une vitesse de mouvement entre la plaque d'impression et la tête d'exposition frontale linéaire le long de la deuxième dimension de la plaque dans un ou plusieurs cycles d'exposition frontale, chaque cycle d'exposition frontale comprenant un mouvement relatif dans une première direction de mouvement à travers une deuxième dimension complète de la plaque pendant qu'au moins certaines de la pluralité de sources ponctuelles de rayonnement UV LED frontales sont activées ;
un dispositif de commande (710, 840) connecté à la pluralité de sources de rayonnement et aux moyens destinés à provoquer un mouvement relatif, le dispositif de commande étant configuré pour activer et désactiver la pluralité de sources ponctuelles de rayonnement UV LED et pour commander l'exposition de la plaque polymère à l'aide de la vitesse de déplacement, l'activation et la désactivation sélectives des sous-groupes linéaires, ou une combinaison de celles-ci, afin d'amener la plaque à recevoir une quantité d'énergie d'exposition totale appliquée à la plaque par la tête d'exposition frontale linéaire,
sachant que le dispositif de commande est en outre configuré pour activer et désactiver sélectivement les sous-groupes linéaires afin d'imiter un mouvement relatif des sous-groupes linéaires par rapport à la plaque.

2. L'appareil d'après la revendication 1, sachant que la pluralité de sources ponctuelles de rayonnement UV LED frontales ont une intensité fixe.

3. L'appareil d'après la revendication 1 ou la revendication 2, sachant que le dispositif de commande est configuré pour commander l'énergie d'exposition totale appliquée à la plaque par la tête d'exposition frontale linéaire dans un temps d'exposition donné en commandant un nombre total maximal de sous-groupes linéaires activés simultanément ; et/ou
sachant que le dispositif de commande est configuré pour répartir l'énergie d'exposition totale appliquée à la plaque par la tête d'exposition frontale linéaire sur une pluralité de cycles d'exposition frontale.

4. L'appareil d'après l'une quelconque des revendications de 1 à 3, comprenant en outre une source d'exposition UV arrière (730, 820) configurée pour émettre un rayonnement vers une face arrière de la plaque disposée sur le substrat, sachant que le dispositif de commande est configuré pour commander la source d'exposition UV arrière afin d'appliquer l'exposition arrière séquentiellement avant un premier cycle d'exposition avant, entre une paire de cycles d'exposition frontale séquentiels, ou une combinaison de ceux-ci ; et facultativement :
sachant que la source d'exposition arrière est configurée pour émettre le rayonnement vers la face arrière de la plaque dans un champ d'irradiation arrière coextensif avec la première dimension latérale de la plaque et coextensif avec la deuxième dimension latérale de la plaque ; ou
sachant que la source d'exposition arrière est configurée pour émettre le rayonnement vers la face arrière de la plaque dans un champ d'irradiation arrière coextensif avec la première dimension latérale de la plaque et non coextensif avec la deuxième dimension latérale de la plaque,
et de préférence sachant que la source d'exposition arrière précède la source d'exposition frontale dans la première direction de déplacement, et qu'une distance entre un bord avant de la source d'exposition frontale et un bord avant de la source d'exposition arrière est réglable de manière qu'une différence de temps constante entre le début de l'exposition arrière et le début de l'exposition frontale soit réalisable pour une plage de vitesses de déplacement.

5. L'appareil d'après l'une quelconque des revendications de 1 à 4, sachant qu'un ou plusieurs des sous-groupes linéaires positionnés de manière adjacente à un bord avant de la tête d'exposition frontale linéaire comprennent des sources ponctuelles LED UV présentant une intensité plus élevée que des sources ponctuelles LED UV correspondantes dans les sous-groupes linéaires restants, qui présentent une intensité plus faible ; et/ou
sachant que le ou les sous-groupes linéaires positionnés de manière adjacente à un bord avant de la tête d'exposition frontale linéaire sont commandables entre au moins l'intensité plus élevée et l'intensité plus faible ; et/ou
sachant que le dispositif de commande est configuré pour provoquer l'émission du champ d'irradiation collectif uniquement dans la première direction de déplacement.

6. L'appareil d'après l'une quelconque des revendications de 1 à 5, sachant que la tête d'exposition frontale linéaire présente une position de repos initiale et une position de repos finale, et que dans au moins l'une parmi la position de repos initiale et la position de repos finale, un ou plusieurs des sous-groupes linéaires sont positionnés pour éclairer une portion de la plaque lorsqu'ils sont dans un état activé.

7. L'appareil d'après la revendication 6, sachant que le dispositif de commande est configuré pour activer et désactiver sélectivement les sous-groupes linéaires dans une première séquence afin d'imiter le mouvement relatif des sous-groupes linéaires par rapport à la plaque dans une première partie d'au moins un cycle d'exposition dans lequel la tête d'exposition frontale linéaire se trouve dans la position de repos initiale, provoquer un mouvement relatif réel dans la première direction de déplacement dans une deuxième partie dudit au moins un cycle d'exposition, et d'activer et de désactiver sélectivement les sous-groupes linéaires dans une deuxième séquence afin d'imiter le mouvement relatif des sous-groupes linéaires par rapport à la plaque avec la tête d'exposition frontale linéaire dans la position de repos finale dans une troisième partie dudit au moins un cycle d'exposition ; et/ou
sachant que le dispositif de commande est configuré pour faire revenir la tête d'exposition frontale linéaire de la position de repos finale à la position de repos initiale dans une deuxième direction de mouvement opposée à la première direction de mouvement sans qu'aucun des sous-groupes linéaires ne soit activé ; et/ou
sachant que le dispositif de commande est configuré pour provoquer une troisième séquence d'activation et de désactivation sélectives des sous-groupes linéaires dans une quatrième partie dudit au moins un cycle d'exposition avec la tête d'exposition frontale linéaire dans la position de repos finale, provoquer un mouvement relatif réel dans une deuxième direction de déplacement opposée à la première direction de déplacement dans une cinquième partie dudit au moins un cycle d'exposition, et pour provoquer une quatrième séquence d'activation et de désactivation sélectives des sous-groupes linéaires dans une sixième partie dudit au moins un cycle d'exposition avec la tête d'exposition linéaire frontale dans la position de repos initiale.

8. L'appareil d'après la revendication 7, sachant que le dispositif de commande est configuré pour activer tous les sous-groupes linéaires pendant la deuxième partie dudit au moins un cycle d'exposition, ou
sachant que le dispositif de commande est configuré pour activer moins que tous les sous-groupes linéaires pendant la deuxième partie dudit au moins un cycle d'exposition.

9. L'appareil d'après l'une quelconque des revendications de 1 à 8, sachant que le dispositif de commande est configuré pour activer moins que tous les sous-groupes linéaires pendant une partie mouvement relatif dudit au moins un cycle d'exposition.

10. L'appareil d'après l'une quelconque des revendications de 1 à 9, sachant qu'au moins une paire adjacente de la ou des sous-sources linéaires est espacée l'une de l'autre d'un espacement qui est réglable ; et/ou
sachant que plusieurs paires adjacentes de sous-sources linéaires présentent un espacement réglable entre elles et sont reliées les unes aux autres par un mécanisme configuré pour régler l'espacement entre plusieurs paires adjacentes à l'aide d'un seul dispositif d'entraînement, ou sachant que plusieurs paires adjacentes de sous-sources linéaires présentent un espacement réglable entre elles, et que chaque sous-source linéaire dans les multiples paires adjacentes est reliée à un positionneur pouvant être commandé indépendamment.

11. L'appareil d'après la revendication 10, sachant que le dispositif de commande est configuré pour réguler l'intensité de l'exposition en ajustant l'espacement entre deux ou plusieurs sous-sources.

12. L'appareil d'après l'une quelconque des revendications de 1 à 11, sachant que le dispositif de commande est configuré pour provoquer l'exposition d'une portion de la plaque dans la première direction de déplacement en provoquant le déplacement d'une première sous-source linéaire activée dans la première direction de déplacement par rapport à une deuxième sous-source linéaire,
sachant que, facultativement, le dispositif de commande est configuré pour provoquer le déplacement de la première sous-source linéaire activée par rapport à la deuxième sous-source linéaire à un moment où la deuxième sous-source linéaire n'est pas positionnée au-dessus de la plaque.

13. Un procédé de durcissement d'une plaque d'impression photopolymère flexographique (310, 400, 500, 740, 830) présentant une première dimension latérale et une deuxième dimension latérale, le procédé comprenant le fait de :
disposer la plaque d'impression dans une position permettant de recevoir un rayonnement incident ;
émettre un rayonnement UV avec une tête d'exposition frontale linéaire (300, 720, 810) configurée pour émettre un champ d'irradiation collectif vers une face avant de la plaque disposée sur le substrat, le champ d'irradiation collectif couvrant une surface collective coextensive avec la première dimension latérale de la plaque et non coextensive avec la deuxième dimension latérale de la plaque, la tête d'exposition frontale linéaire comprenant une pluralité de sources ponctuelles de rayonnement UV **LED** frontales agencées en une pluralité de sous-groupes linéaires commandables indépendamment (302, 304, 306 ; 401-407 ; 501-503 ; 722, 724, 726 ; 811-817 ; 102, 104, 106), chaque sous-groupe linéaire étant configuré pour émettre un champ d'irradiation de composante couvrant une surface de composante coextensive avec la première dimension de la plaque, non coextensive avec la deuxième dimension de la plaque, et inférieure à la surface collective du champ d'irradiation collectif ;
déplacer la plaque d'impression et la tête d'exposition frontale linéaire l'une par rapport à l'autre à une vitesse de déplacement le long de la deuxième dimension de la plaque dans un ou plusieurs cycles d'exposition frontale, chaque cycle d'exposition frontale comprenant un mouvement relatif dans une première direction de mouvement à travers une deuxième dimension complète de la plaque tandis qu'au moins certaines de la pluralité de sources ponctuelles de rayonnement UV **LED** frontales émettent un rayonnement UV ;
commander l'exposition de la plaque polymère en utilisant une combinaison de la vitesse de déplacement et de l'activation et la désactivation sélectives des sous-groupes linéaires, amenant ainsi la plaque à recevoir une quantité d'énergie d'exposition totale appliquée à la plaque par la tête d'exposition frontale linéaire, sachant que la commande comprend l'activation et la désactivation sélectives des sous-groupes linéaires pour imiter le mouvement relatif des sous-groupes linéaires par rapport à la plaque.

14. Le procédé d'après la revendication 13, comprenant le fait de contrôler la géométrie supérieure des points d'impression en contrôlant un nombre total maximal de sous-groupes linéaires activés simultanément pendant ledit au moins un cycle d'exposition frontale.
